# EUROPEAN PATENT APPLICATION

(11) **EP 4 543 153 A1**
(43) Date of publication of application: **23.04.2025**
(21) Application number: 23838422.6
(22) Date of filing: 01.03.2023
(51) Int. Cl.: H05K 7/20

(54) **COMPUTING DEVICE AND COOLANT DISTRIBUTION UNIT BASED ON PHASE-CHANGE IMMERSION LIQUID COOLING SYSTEM**

(30) Priority: 13.07.2022 CN 202210820435
(71) Applicant: Huawei Cloud Computing Technologies Co., Ltd., Guiyang, Guizhou 550025 (CN)
(72) Inventor: YAO, Xidong, Guiyang, Guizhou 550025 (CN)
(74) Representative: Körber, Martin Hans
(86) International application number: PCT/CN2023/078953
(87) International publication number: WO 2024/011920

(57) **Abstract**

A computing device and a phase-change liquid immersion cooling system-based coolant distribution unit are provided. An external housing of the coolant distribution unit is disposed on a back surface of a device chassis, and a condensation component is built in the housing. The condensation component and a condensation region wall surface on a front surface of the housing are disposed opposite to each other in a front-rear direction. In addition, a liquid connector and a vapor connector are disposed on the condensation region wall surface, and are configured to be disposed opposite to and respectively adaptively connected to connectors of a vapor introduction port and a liquid introduction port disposed on the device chassis. During an assembly operation, vapor path and liquid path connection and communication between the device chassis and the coolant distribution unit may be implemented by inserting or pushing the device chassis. After assembly, the coolant distribution unit is located on a rear side of the device chassis without occupying the effective device arrangement space, so that a system integration degree is high on a basis of meeting functions such as vapor coolant condensation processing and liquid coolant distribution.

## Description

This application claims priority to Chinese Patent Application No. 202210820435.5, filed with the China National Intellectual Property Administration on July 13, 2022 and entitled "COMPUTING DEVICE AND PHASE-CHANGE LIQUID IMMERSION COOLING SYSTEM-BASED COOLANT DISTRIBUTION UNIT", which is incorporated herein by reference in its entirety.

### TECHNICAL FIELD

Embodiments of this application relate to the field of computer hardware, and in particular, to a computing device and a phase-change liquid immersion cooling system-based coolant distribution unit.

### BACKGROUND

With development of computing devices toward a high power, a high integration degree, and a large scale, high-performance chips and integrated circuits are used more widely. Heat generated when these high heat flux components work is a main source of heat loads of the computing devices. A data center server is used as an example. A conventional air cooling system cannot meet a heat dissipation requirement. To ensure stability and reliability of the data center server, research, development, and design of a liquid cooling technology has become a key link of a data center system design, especially, a liquid immersion cooling technology, which has attracted the attention of the industry with an excellent heat dissipation capability.

Liquid immersion cooling may be classified into single-phase liquid immersion cooling and phase-change liquid immersion cooling based on whether a phase change occurs on a coolant. For the phase-change liquid immersion cooling, cooling liquid is boiled and vaporized to take away heat generated by a device. Usually, a sealed design filled with a specific amount of phase-change coolant is used. After the server works, the heat generated by the device causes a liquid coolant in a cooling system to be vaporized, and a vapor coolant is cooled on a surface of a condensation component and changes into the liquid coolant, and flows back to a server chassis.

In a case in which a plurality of nodes are disposed in a server, a typical processing solution in the conventional technology uses a CDU (Coolant distribution unit, coolant distribution unit) to separately control the server nodes. To meet a heat dissipation requirement of a high-density load, the CDU is designed to be of a large size and occupies an effective arrangement space of the server nodes, for example, is disposed above or below the nodes in a cabinet, or occupies a cabinet between adjacent cabinets, thus affecting server arrangement density.

### SUMMARY

Embodiments of this application provide a computing device and a phase-change liquid immersion cooling system-based coolant distribution unit, to ensure stable and reliable system operation without occupying an effective device space.

According to a first aspect of the embodiments of this application, a phase-change liquid immersion cooling system-based coolant distribution unit is provided. The coolant distribution unit includes an external housing and a condensation component built in the housing. The external housing of the coolant distribution unit is configured to be disposed on a back surface of a device chassis without occupying an effective device arrangement space. A front surface of the housing is configured as a condensation region wall surface, and the condensation region wall surface and the condensation component are disposed opposite to each other in a front-rear direction. A liquid connector and a vapor connector are disposed on the condensation region wall surface, and the liquid connector and the vapor connector are configured to be disposed opposite to and respectively adaptively connected to connectors of a vapor introduction port and a liquid introduction port disposed on the device chassis, to quickly establish a vapor path communication relationship and a liquid path communication relationship between the device chassis and the coolant distribution unit. During an assembly operation, vapor path and liquid path connection and communication between the device chassis and the coolant distribution unit may be implemented by inserting or pushing the device chassis. After assembly, the coolant distribution unit is located on a rear side of the device chassis without occupying the effective device arrangement space, so that a system integration degree is high on a basis of meeting functions such as vapor coolant condensation processing and liquid coolant distribution.

In addition, based on a structural feature that the coolant distribution unit is deployed at a back part of the device chassis, the condensation region wall surface may be configured to be at least approximately the same amplitude as the effective device arrangement space, so that sizes of the condensation region wall surface and the effective device arrangement space tend to be consistent in a height direction and a width direction. Therefore, a heat exchange pipe of the condensation component may be arranged in a large area within a corresponding amplitude range, to make full use of a back space of a device to improve a condensation capability, thereby improving heat dissipation efficiency of the entire unit. In addition, the device chassis and the coolant distribution unit are quickly connected by using adaptive connectors, to reduce operation duration of previous pipeline connection. In addition, actual vapor and liquid connection paths between the device chassis and the coolant distribution unit are short, thereby avoiding a leakage problem that may be caused by pipeline connection.

In specific application, a liquid storage part is located at a bottom of the housing, and the condensation component is located above the liquid storage part. Therefore, a structure of the entire unit has a higher integration degree on a basis of meeting a condensation liquid collection function of the coolant distribution unit.

Based on the first aspect, the embodiments of this application further provide a second implementation of the first aspect: The coolant distribution unit further includes an adjustment component. An internal cavity of the adjustment component is communicated with an internal cavity of the housing, the adjustment component includes a main body having the internal cavity, and the main body of the adjustment component may deform under the action of a pressure on an internal cavity side of the adjustment component, to correspondingly change an accommodating space of the internal cavity of the adjustment component. When a vaporization speed is greater than a condensation speed, an internal pressure also increases. Based on a feature that the adjustment component may deform under the pressure, a system internal pressure may be released after the main body of the adjustment component deforms and expands, so that a system pressure is effectively balanced, thereby avoiding an adverse impact caused by an increase in the internal pressure, for example, but not limited to, a boiling point of a coolant increases due to an excessively high pressure, which may cause a damage to a chip due to overtemperature, and avoiding affecting normal working of some pressure-sensitive components and another potential safety hazard. In general, system operation can be maintained at normal pressure, thereby reducing a pressure fluctuation amplitude in a working process and ensuring stable and reliable system operation.

Based on the second implementation of the first aspect, the embodiments of this application further provide a third implementation of the first aspect: The adjustment component is located on a rear side of the housing, and is capable of extending and contracting in the front-rear direction to change the accommodating space of the internal cavity of the adjustment component. In such disposition, horizontal and vertical dimensional spaces are fully used, so that a size of the adjustment component in the front-rear direction is properly controlled on a basis of providing a same pressure balancing capability, and an integration degree of the entire unit is high. In addition, space occupation in an expanded state may be reduced in the front-rear direction, thereby facilitating overall deployment of an application space such as an equipment room.

Based on the third implementation of the first aspect, the embodiments of this application further provide a fourth implementation of the first aspect: A plurality of adjustment components are sequentially disposed in an up-and-down direction, to make full use of a back space of a device. In the working process, when pressures of regions in which adjustment components are located are different, corresponding actual expansion amounts are not completely the same. In addition, for a case in which vaporization speeds in server nodes are different, redundancy supplement between corresponding regions in which the adjustment components are located can be provided based on expansion adjustment capabilities of internal cavities of the adjustment components.

Based on the first aspect, the first implementation of the first aspect, the second implementation of the first aspect, the third implementation of the first aspect, or the fourth implementation of the first aspect, the embodiments of this application further provide a fifth implementation of the first aspect: The coolant distribution unit further includes a flow distribution manifold disposed on the housing, where the flow distribution manifold may be communicated with the liquid storage part, and a plurality of liquid connectors are inserted into the flow distribution manifold. In general, a liquid coolant is distributed to the liquid connectors in a centralized manner, and liquid supply pressures may be maintained approximately the same, thereby ensuring a uniform heat dissipation supply capability.

In specific application, the flow distribution manifold is fastened on the front surface of the housing, that is, fastened outside the housing, so that the condensation component is disposed close to the condensation region wall surface, thereby ensuring a vapor coolant can quickly reach a surface of a heat exchange pipe for heat dissipation and condensation.

In other specific application, the coolant distribution unit further includes a liquid supply pump, configured to transport a liquid coolant in the liquid storage part to the flow distribution manifold. For example, the liquid supply pump may be built in the liquid storage part.

Based on the first aspect, the first implementation of the first aspect, the second implementation of the first aspect, the third implementation of the first aspect, the fourth implementation of the first aspect, or the fifth implementation of the first aspect, the embodiments of this application further provide a sixth implementation of the first aspect: A plurality of groups of liquid connectors and vapor connectors may be disposed, and each group includes at least one liquid connector and at least one vapor connector. In such disposition, corresponding to a plurality of device chassis, vapor path communication and liquid path communication may be established for each device chassis by using one group of vapor and liquid connectors, to implement precise coolant management and distribution.

In other actual application, two or more groups of vapor and liquid connectors may alternatively be correspondingly configured for each device chassis, to meet a component heat dissipation requirement in the device chassis.

Based on the first aspect, the first implementation of the first aspect, the second implementation of the first aspect, the third implementation of the first aspect, the fourth implementation of the first aspect, the fifth implementation of the first aspect, or the sixth implementation of the first aspect, the embodiments of this application further provide a seventh implementation of the first aspect: The liquid connector and the vapor connector are quick connectors, and may be used in different application scenarios with a plurality of computing nodes, for example, a server cabinet. The plurality of groups of liquid connectors and vapor connectors are sequentially disposed from top to bottom, to facilitate more proper pipeline arrangement and connection. In addition, a node chassis may be inserted horizontally, to obtain a good phase-change heat dissipation capability.

Based on the first aspect, the first embodiment of the first aspect, the second embodiment of the first aspect, the third embodiment of the first aspect, the fourth embodiment of the first aspect, the fifth implementation of the first aspect, the sixth implementation of the first aspect, or the seventh implementation of the first aspect, the embodiments of this application further provide an eighth implementation of the first aspect: The condensation component includes a water inlet pipe, a water outlet pipe, and a heat exchange member separately communicated between the water inlet pipe and the water outlet pipe. The heat exchange member includes a cooling water flow channel. Low-temperature cooling water flowing through the water inlet pipe performs heat exchange with a main body of the heat exchange member, and high-temperature cooling water obtained after heat exchange flows back through the water outlet pipe. In this way, the back space of the device is fully used to arrange a condensation heat exchange member, for example, but not limited to, a condensation coiled pipe, which is arranged in a large area within the amplitude range, thereby improving a condensation capability and meeting a heat dissipation processing requirement of a high-computing-power device.

In actual application, at least two condensation components are disposed, and water inlet pipes and water outlet pipes of the at least two condensation components are communicated in parallel. In this way, cooling water flow rates of the condensation components may be flexibly adjusted, and properly distributed according to a specific heat dissipation requirement.

Based on the first aspect, the first implementation of the first aspect, the second implementation of the first aspect, the third implementation of the first aspect, the fourth implementation of the first aspect, the fifth implementation of the first aspect, the sixth implementation of the first aspect, the seventh implementation of the first aspect, or the eighth implementation of the first aspect, the embodiments of this application further provide a ninth implementation of the first aspect: The heat exchange member is a heat exchange pipe, and the vapor connector is disposed opposite to the heat exchange pipe in the front-rear direction. In this way, the vapor coolant flowing through the vapor connector travels a short distance to reach the surface of the heat exchange pipe, and changes into the liquid coolant after quick heat dissipation and condensation on the surface of the heat exchange pipe. Therefore, heat exchange efficiency is high.

For example, a through-flow center of the vapor connector may intersect with a center of a corresponding heat exchange pipe, or a through-flow section of the vapor connector at least partially overlaps the surface of the main body of the heat exchange pipe.

Based on the ninth implementation of the first aspect, the embodiments of this application further provide a tenth implementation of the first aspect: The water inlet pipe and the water outlet pipe may be vertically disposed, a plurality of heat exchange pipes are configured, and the heat exchange pipe includes a horizontally extended pipe section. Herein, the back space of the device may be used for arrangement in an array form, to achieve good structural manufacturability. For example, but not limited to, one heat exchange pipe is correspondingly disposed for a vapor outlet corresponding to each vapor connector. The server node is used as an example. Corresponding to one server node, path lengths of vapor paths between server nodes and the coolant distribution unit are consistent, so that heat dissipation effects or provided heat dissipation capabilities tend to be consistent, thereby avoiding problems that a specific server node is far away from the coolant distribution unit and has poor heat dissipation, and this node with poor heat dissipation is used to represent an upper limit of a heat dissipation capability of the entire system. Therefore, a uniform liquid cooling distribution capability may be provided.

Based on the tenth implementation of the first aspect, the embodiments of this application further provide an eleventh implementation of the first aspect: A flow guiding baffle is disposed below the heat exchange pipe, and an extension end of the flow guiding baffle is located on a side of the heat exchange pipe. In this way, when the liquid coolant drops downward, the liquid coolant first reaches the flow guiding baffle below the liquid coolant, is guided to the side of the heat exchange pipe by the flow guiding baffle to drop downward, and is collected in the liquid storage part, thereby preventing the liquid coolant dropping downward from attaching to a surface of a lower heat exchange pipe, and avoiding affecting contact and heat exchange between the condensation heat exchange pipe and the vapor coolant.

For example, the flow guiding baffle may be an inclined flat plate, and has a simple structure and is easy to manufacture.

In other specific application, a pipe body of the heat exchange pipe may be inclined. In such disposition, the liquid coolant formed through condensation on the surface of the heat exchange pipe may flow to a lower end along the inclined pipe body. In this way, an amount of liquid that directly drops downward can be reduced, thereby reducing an impact on condensation efficiency of a lower heat exchange pipe.

Based on the first aspect, the first implementation of the first aspect, the first implementation of the first aspect, the second implementation of the first aspect, the third implementation of the first aspect, the fourth implementation of the first aspect, the fifth implementation of the first aspect, the sixth implementation of the first aspect, the seventh implementation of the first aspect, the eighth implementation of the first aspect, the ninth implementation of the first aspect, the tenth implementation of the first aspect, or the eleventh implementation of the first aspect, the embodiments of this application further provide a twelfth implementation of the first aspect: A top or a bottom of the housing includes a cooling water outlet and a cooling water inlet, which are respectively communicated with the water outlet pipe and the water inlet pipe of the condensation component. In such disposition, the cooling water outlet and inlet of the condensation component are disposed at the top or the bottom of the housing. In other words, a pipeline configured to establish cooling water circulation is led out from the top or the bottom, and does not occupy a space in the width direction, thereby facilitating compact arrangement of the entire unit.

According to a second aspect of the embodiments of this application, a computing device is provided. The computing device includes a device chassis that performs component heat dissipation based on a phase-change liquid immersion cooling system, and further includes the phase-change liquid immersion cooling system-based coolant distribution unit described above, where a liquid connector and a vapor connector on the device chassis are located on a back surface of the device chassis, and the liquid connector and the vapor connector on the device chassis are respectively adaptively connected to the liquid connector and the vapor connector on the housing, to respectively establish a liquid path communication relationship and a vapor path communication relationship.

Based on the second aspect, the embodiments of this application further provide a second implementation of the second aspect: The device chassis includes a plurality of node device chassis, and the liquid connectors and the vapor connectors on the housing are respectively communicated with liquid connectors and vapor connectors of the plurality of node device chassis in one-to-one correspondence. That is, the vapor path communication relationship and the liquid path communication relationship are established for one node device chassis based on one pair of liquid connector and vapor connector on the coolant distribution unit, to achieve independent control and management, and facilitate a maintenance operation.

In specific application, the computing device may be of a product type such as a computer or a server. For example, the computing device may be a server, and the device chassis is a liquid immersion cooling node device chassis mounted in a server cabinet.

For example, the computing device may be a server cabinet. Compared with a manner in which the plurality of node device chassis nodes are vertically inserted, according to a manner in which the nodes are horizontally inserted, a phase-change heat dissipation capability is better, a component immersion area of a component in the chassis is relatively large, and an overall heat dissipation capability is stronger. In addition, for the manner in which the node are vertically inserted, at least one flow distribution manifold needs to be arranged for each row of node to establish the liquid path communication relationship. However, the nodes horizontally inserted in an entire cabinet body may be sequentially arranged based on one flow distribution manifold, and fully distributed on a rear side of the entire cabinet. Therefore, a structure is simple and manufacturability is good.

### BRIEF DESCRIPTION OF DRAWINGS

FIG. 1 is a diagram of an assembly relationship of a phase-change liquid immersion cooling system-based coolant distribution unit according to an embodiment of this application;
FIG. 2 is a diagram of assembly of a phase-change liquid immersion cooling system-based coolant distribution unit from another perspective according to an embodiment of this application;
FIG. 3 is an A-A cross-sectional view of FIG. 1;
FIG. 4 is a front view of the coolant distribution unit shown in FIG. 1;
FIG. 5 is a top view along a C direction of FIG. 4;
FIG. 6 is a diagram of a server node according to an embodiment of this application;
FIG. 7 is a diagram of an internal structure of the server node shown in FIG. 6;
FIG. 8 is a diagram of a structure of a condensation component according to an embodiment of this application;
FIG. 9 is a diagram of an assembly relationship between a condensation component and a housing according to an embodiment of this application;
FIG. 10 is an enlarged view of a part D of FIG. 3;
FIG. 11 is an exploded view of assembly of a phase-change liquid immersion cooling system-based coolant distribution unit according to an embodiment of this application;
FIG. 12 is an exploded view of another assembly of a phase-change liquid immersion cooling system-based coolant distribution unit according to an embodiment of this application;
FIG. 13 is a diagram of an adjustment component in an expanded state according to an embodiment of this application;
FIG. 14 is a diagram of a maintenance state of a phase-change liquid immersion cooling system-based coolant distribution unit according to an embodiment of this application;
FIG. 15 is a diagram of an assembly relationship between a coolant distribution unit and a cabinet body according to an embodiment of this application;
FIG. 16 and FIG. 17 are respectively diagrams from two perspectives that are formed through cutting from a position E-E in FIG. 1;
FIG. 18 is a diagram of a working principle of a phase-change liquid immersion cooling system-based coolant distribution unit according to an embodiment of this application;
FIG. 19 is another diagram of a local part of a phase-change liquid immersion cooling system-based coolant distribution unit according to an embodiment of this application;
FIG. 20 is a diagram of another condensation component according to an embodiment of this application;
FIG. 21 is a diagram of still another condensation component according to an embodiment of this application;
FIG. 22 is a diagram of another condensation component according to an embodiment of this application;
FIG. 23 is a diagram of still another condensation component according to an embodiment of this application;
FIG. 24 is a diagram of another condensation component according to an embodiment of this application; and
FIG. 25 is a diagram of still another condensation component according to an embodiment of this application.

### DESCRIPTION OF EMBODIMENTS

Embodiments of this application provide a phase-change liquid immersion cooling system-based coolant distribution unit, to ensure stable and reliable system operation without occupying an effective device space.

In the conventional technology, a CDU (Coolant Distribution Unit, coolant distribution unit) used in a phase-change liquid immersion cooling system is designed to be of a large size, to meet a heat dissipation requirement of a high-density load. In addition, most large CDUs occupy effective arrangement spaces of computing devices. Herein, the "effective arrangement space" refers to a space that is in an arrangement plane of the computing device and that is used for a high-density layout. A server cabinet is used as an example. A typical CDU arrangement manner is that a CDU is disposed above or below a node in the cabinet or a CDU occupies a cabinet between adjacent cabinets, which affects server arrangement density. In addition, in the foregoing arrangement manner, to transport a vapor coolant in a chassis to the CDU for condensation processing, and then transport a liquid coolant to the chassis, corresponding pipelines are required between the CDU and a server chassis, resulting in a large assembly and maintenance workload and a leakage problem in pipeline connection.

Based on this, an embodiment of this application provides a phase-change liquid immersion cooling system-based coolant distribution unit. The coolant distribution unit is configured to be disposed on a back surface of a device chassis, and includes an external housing and a condensation component built in the housing. A front surface of the housing is configured as a condensation region wall surface, and a liquid connector and a vapor connector are disposed on the condensation region wall surface. The "front surface of the housing" herein refers to a wall surface that is of the housing and that is directly opposite to a back part of the device chassis in a front-rear direction. The condensation region wall surface and the condensation component are disposed opposite to each other in the front-rear direction, and the liquid connector and the vapor connector are configured to be disposed opposite to and respectively adaptively connected to connectors of a vapor introduction port and a liquid introduction port disposed on the device chassis, to quickly establish a vapor path communication relationship and a liquid path communication relationship between the device chassis and the coolant distribution unit. The "device chassis" herein refers to an external chassis of a computing device that uses phase-change liquid immersion cooling, and a component configured according to a product design requirement is mounted in the device chassis. A main body of the device chassis is a sealed structure that accommodates a phase-change coolant, and the device chassis has an external connection interface that meets a function requirement.

During an assembly operation, vapor path and liquid path connection and communication between the device chassis and the coolant distribution unit may be implemented by inserting or pushing the device chassis. In this embodiment of this application, the coolant distribution unit does not occupy an effective device arrangement space, thereby ensuring a system integration degree of a high-density arrangement to the utmost extent on a basis of meeting functions such as vapor coolant condensation processing and liquid coolant distribution. In addition, based on a structural feature that the coolant distribution unit is deployed at a back part of the device chassis, the condensation region wall surface may be configured as at least approximately the same amplitude as the effective device arrangement space. In other words, sizes of the condensation region wall surface and the effective device arrangement space tend to be consistent in a height direction and a width direction. Correspondingly, the condensation component may be arranged in a large area within a corresponding amplitude range, to make full use of a back space of a device to improve a condensation capability, thereby effectively improving heat dissipation efficiency of the entire unit.

In addition, in this embodiment of this application, the device chassis and the coolant distribution unit are quickly connected by using adaptive connectors, to reduce operation duration of previous pipeline connection. In addition, actual vapor and liquid connection paths between the device chassis and the coolant distribution unit are short, thereby avoiding a leakage problem that may be caused by pipeline connection, and reducing costs caused by pipeline connection.

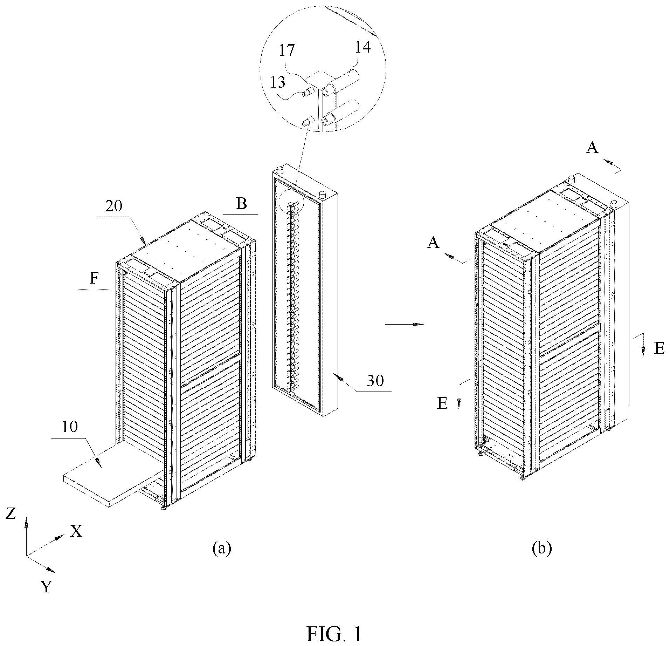

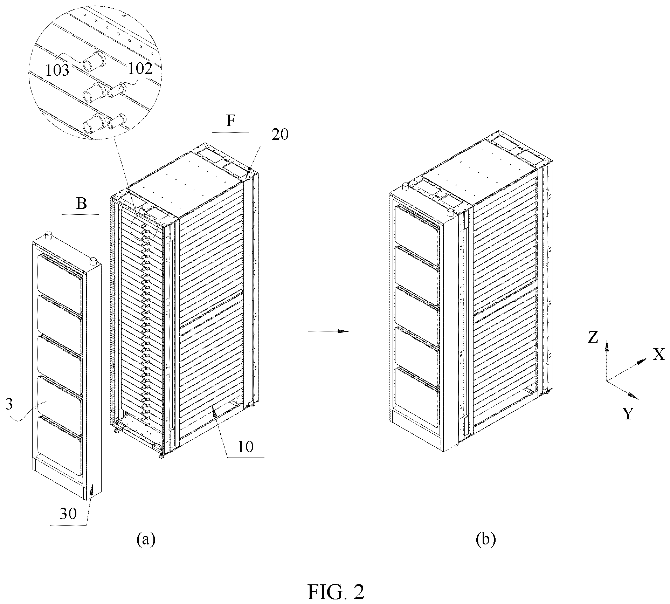

To better understand the technical solutions and technical effects of this application without loss of generality, the following describes specific embodiments in detail with reference to the accompanying drawings and by using a server as a heat dissipation processing object. FIG. 1 and FIG. 2 are respectively diagrams of assembly and application of a phase-change liquid immersion cooling system-based coolant distribution unit from different perspectives. In the figures, an arrow X is used to represent a front-rear direction of a server, that is, an insertion direction of server nodes 10 on a cabinet body 20, an orientation shown by F is marked as a front side of the server nodes 10, and an orientation shown by B is marked as a rear side of the server nodes 10. In addition, an arrow Y and an arrow Z in the figures are respectively used to represent a width direction and a height direction of the server.

A coolant distribution unit 30 provides the server nodes 10 with a liquid coolant, recovers a vapor coolant vaporization, and transports the vapor coolant to the server nodes. In this implementation, the coolant distribution unit 30 is located on the rear side of the server node 10, that is, located on a back surface of a device chassis of the server node 10. (a) of FIG. 1 and (a) of FIG. 2 show relative position relationships between the coolant distribution unit 30 and the cabinet body 20 before assembly, and (b) of FIG. 1 and (b) of FIG. 2 are diagrams of overall structures after assembly.

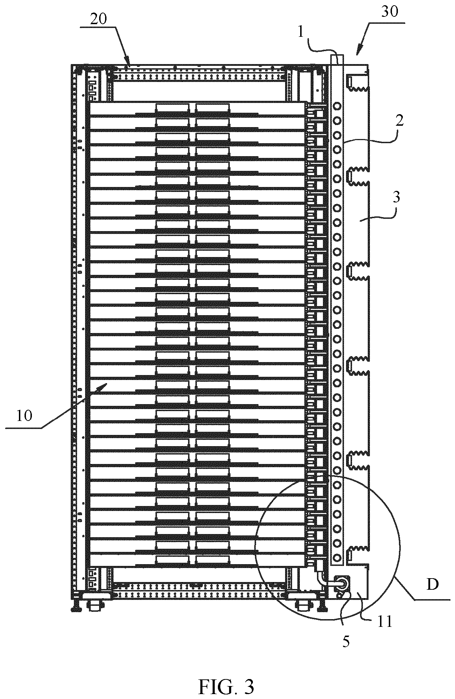

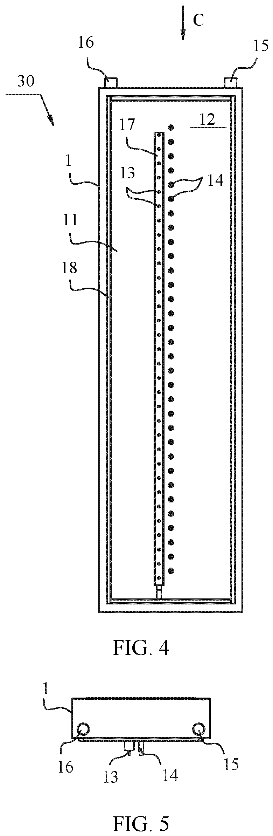

In this embodiment of this application, the coolant distribution unit 30 may include an external housing 1 and a condensation component 2. Refer to FIG. 3, FIG. 4, and FIG. 5. FIG. 3 is an A-A cross-sectional view of FIG. 1, FIG. 4 is a front view of the coolant distribution unit 30 shown in FIG. 1, and FIG. 5 is a top view along a C direction of FIG. 4.

As shown in FIG. 4, a bottom of the housing 1 is a liquid storage part 11, a front surface of the housing 1 is configured as a condensation region wall surface 12, and a plurality of groups of liquid connectors 13 and vapor connectors 14 are disposed on the condensation region wall surface 12. In the front-rear direction X, the condensation component 2 located in the housing 1 is disposed opposite to the condensation region wall surface 12, and the condensation component 2 is located above the liquid storage part 11. The housing 1 may use a heat insulation means, for example, but not limited to, a heat insulation foam layer is coated on a wall surface of the housing 1 or a double-layer heat insulation structure is used for a wall surface of the housing 1.

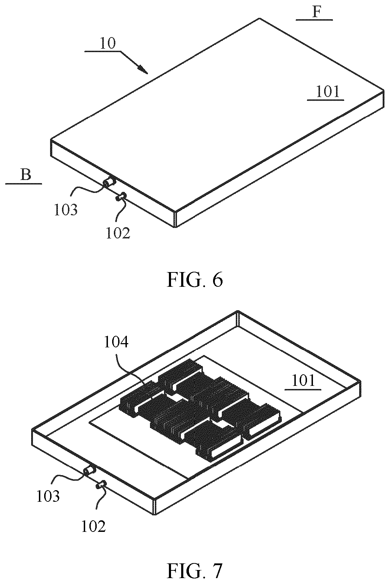

A plurality of pairs of liquid connectors 13 and vapor connectors 14 are disposed on the condensation region wall surface 12 of the housing 1. Each pair of liquid connector 13 and vapor connector 14 are in one-to-one correspondence with each server node 10, and are respectively disposed opposite to and adaptively plug-connected to a liquid connector 102 and a vapor connector 103 on a device chassis 101 of the server node 10. The liquid connectors are adaptively connected to establish liquid path communication, and the vapor connectors are adaptively connected to establish vapor path communication. Refer to FIG. 6 and FIG. 7. FIG. 6 is a diagram of a server node, and FIG. 7 is a diagram of an internal structure of the server node shown in FIG. 6.

The liquid connector 102 and the vapor connector 103 on the server node 10 side are located at a rear end of the device chassis 101. Communication with or disconnection from the corresponding liquid connector 13 and vapor connector 14 on the coolant distribution unit 30 side may be completed by pulling and pushing the device chassis 101. In a specific implementation, adaptive quick connectors may be used to quickly establish a vapor path communication relationship and a liquid path communication relationship between each device chassis 101 and the coolant distribution unit 30. The liquid connector 13, the liquid connector 102, the vapor connector 103, and the vapor connector 14 may be quick connectors with a function of automatic closing upon disconnection, to facilitate on-site operation and management. It can be understood that a specific structure implementation of the function of automatic closing upon disconnection is not a core invention point of this application. Therefore, details are not described in this specification.

In addition, components 104 in the node device chassis 101 may be the same, or may be different, for example, but not limited to, a processor shown in the figure.

In a working process of the server, component operation generates heat and the heat is exchanged to the liquid coolant in the device chassis 101. The liquid coolant is vaporized when a temperature exceeds a boiling point of a two-phase coolant. The vapor coolant may enter the housing 1 through a vapor path that is adaptively established by using the vapor connector 103 and the vapor connector 14, and is cooled and liquefied on a surface of a heat exchange pipe of the condensation component 2. The liquid coolant is accumulated in the liquid storage part 11 at the bottom of the housing 1. The liquid coolant may flow back to the device chassis 101 through a liquid path established by using the liquid connector 13 and the liquid connector 102, and enter a next cycle.

Herein, the liquid storage part 11 located at the bottom of the housing 1 is integrated with the housing. Certainly, the liquid storage part 11 may alternatively be machined as an independent component, and then assembled with the housing 1. In another specific implementation, as a component for accumulating the liquid coolant, the liquid storage part may alternatively be configured at another position of a system, for example, but not limited to, a position for mounting the liquid storage part may be reserved at a bottom of the cabinet body 20, or the liquid storage part is disposed on a rear side of the housing, and a necessary flow guiding structure is used to recover, into the liquid storage part, the liquid coolant that condenses and falls off.

For the plurality of groups of liquid connectors 13 and vapor connectors 14 disposed on the condensation region wall surface 12, in this implementation, each group includes one liquid connector 13 and one vapor connector 14. It can be understood that, in each group of liquid connector 13 and vapor connector 14, a quantity and a relative position relationship of arranged liquid connectors 13 and vapor connectors 14 are not limited to those shown in the figure, and may be specifically configured in pairs based on an actual quantity of objects whose heat is to be dissipated. For example, but not limited to, in a specific implementation, two or more groups of liquid connectors 13 and vapor connectors 14 are configured corresponding to one node device chassis 101. In another specific implementation, one group of liquid connector 13 and vapor connectors 14 is configured corresponding to one node device chassis 101, and this group includes one liquid connector 13 and a plurality of vapor connectors 14, or this group includes a plurality of liquid connectors 13 and one vapor connector 14.

In this implementation, the housing 1 further includes a cooling water outlet 15 and a cooling water inlet 16, which are respectively communicated with two pipe ends of a condensation heat exchange pipe, to establish cooling water circulation to take away heat of the system. With reference to FIG. 4 and FIG. 5, the cooling water outlet 15 and the cooling water inlet 16 are located at a top of the housing 1, to facilitate a specific operation and pipeline arrangement.

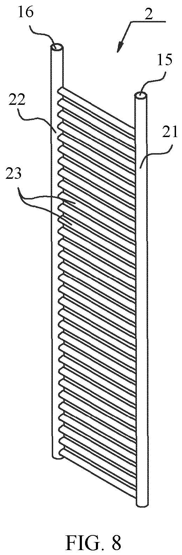

For the cooling water outlet 15 and the cooling water inlet 16 that are located at the top, the condensation component may include a water inlet pipe 21, a water outlet pipe 22, and a plurality of heat exchange pipes 23 that are separately communicated between the water inlet pipe 21 and the water outlet pipe 22. FIG. 8 is a diagram of a structure of a condensation component. Herein, pipe ends at bottoms of the water inlet pipe 21 and the water outlet pipe 22 are sealed after assembly.

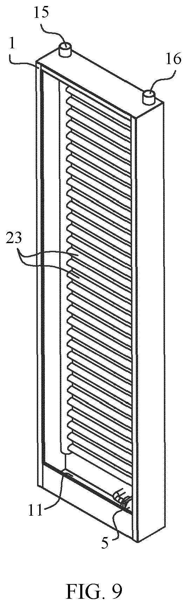

As shown in the figure, the water inlet pipe 21 and the water outlet pipe 22 are disposed vertically, that is, arranged in the height direction Z, and after pipe ends at tops of the water inlet pipe 21 and the water outlet pipe 22 extend out of the housing 1, the cooling water inlet 16 and the cooling water outlet 15 that are connected to a cold source side are respectively formed. FIG. 9 is a diagram of an assembly relationship between the condensation heat exchange pipe and the housing 1.

In another specific implementation, the water inlet pipe 21 and the water outlet pipe 22 may alternatively be completely disposed in the housing 1, and the pipe ends at the tops of the water inlet pipe 21 and the water outlet pipe 22 are respectively connected to the cooling water outlet 15 and the cooling water inlet 16 that are disposed at the top of the housing 1, so that a low-temperature cooling water path and a high-temperature cooling water path for cooling water circulation can also be established. After low-temperature cooling water enters the water inlet pipe 21, the low-temperature cooling water sequentially passes through the heat exchange pipes 23 that are arranged in an approximately horizontal manner, that is, arranged in the width direction Y. In a flow process, the low-temperature cooling water exchanges heat with pipe bodies to obtain high-temperature cooling water, and then the high-temperature cooling water is converged to the water outlet pipe 22 to flow out, to take away heat. It can be understood that heat exchanged to the cooling water is taken away through high-temperature cooling water circulation. After heat exchange is completed, the low-temperature cooling water is recycled to the condensation component 2. A specific function implementation of cooling water circulation may use the conventional technology. Therefore, details are not described in this specification.

In another specific implementation, the cooling water outlet 15 and the cooling water inlet 16 may alternatively be disposed at the bottom of the housing 1 as required, so that a structure is simple and on-site assembly is convenient. Certainly, the cooling water outlet 15 and the cooling water inlet 16 may alternatively be located on two sides of the housing 1. In comparison, as shown in the figure, the manner in which the cooling water outlet 15 and the cooling water inlet 16 are disposed at the top of the housing or the manner in which the cooling water outlet 15 and the cooling water inlet 16 are disposed at the bottom of the housing does not occupy a space in the width direction Y. Therefore, it is more conducive to compact cabinet arrangement. In addition, based on a relative position relationship between the coolant distribution unit 30 and the housing 1, the heat exchange pipes 23 of the condensation component 2 may be deployed in a large area from top to bottom, thereby enhancing a heat dissipation capability.

It should be understood that a specific implementation of a condensation circulation water path is not a core invention point of this application, and a person skilled in the art can implement the condensation circulation water path based on the conventional technology. Therefore, details are not described in this specification.

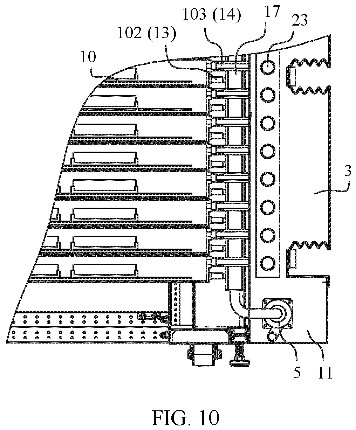

In this implementation, each vapor connector 14 and each heat exchange pipe 23 are disposed opposite to each other in the front-rear direction. FIG. 10 is a diagram of an assembly relationship between a heat exchange pipe and a corresponding liquid connector according to an embodiment of this application. "Disposed opposite to each other" herein includes a case, shown in the figure, in which a through-flow center of the vapor connector 14 intersects with a center of the heat exchange pipe 23, and also includes a case in which a through-flow section of the vapor connector 14 at least partially overlaps the surface of a main body of the heat exchange pipe 23 (not shown in the figure).

To obtain better heat dissipation and condensation efficiency, as shown in FIG. 10, one heat exchange pipe 23 is correspondingly disposed for a vapor outlet corresponding to each vapor connector 14, that is, one heat exchange pipe 23 is used as a main condensation and heat exchange body corresponding to one server node. It can be understood that, in another specific implementation, a quantity of arranged heat exchange pipes 23 may be determined based on a through-flow rate of the heat exchange pipe and a spacing between the heat exchange pipes, instead of being limited to a manner in which the heat exchange pipes are in one-to-one correspondence with the vapor connectors shown in the figure.

The vapor coolant flowing through the vapor connector 14 travels a short distance to reach the surface of the heat exchange pipe 23, and changes into the liquid coolant after quick heat dissipation and condensation on the surface of the heat exchange pipe 23. Therefore, heat exchange efficiency is high. In addition, path lengths of vapor paths between the server nodes 10 and the coolant distribution unit 30 are consistent, so that heat dissipation effects or provided heat dissipation capabilities tend to be consistent, thereby avoiding problems that a specific server node is far away from the coolant distribution unit 30 and has poor heat dissipation, and this node with poor heat dissipation is used to represent an upper limit of a heat dissipation capability of the entire system, and avoiding a direct impact on comprehensive determining for maintenance of the entire unit.

As shown in FIG. 10, the liquid coolant in the liquid storage part 11 is separately transported to each liquid connector 13 through a flow distribution manifold 17, and enters a corresponding device chassis 101 through the liquid path established by using the liquid connector 13 and the liquid connector 102. Refer to FIG. 4 and FIG. 5. The flow distribution manifold 17 is fastened outside the housing 1, a manifold body is arranged in a vertical direction, and the liquid connectors 13 are sequentially disposed on the flow distribution manifold 17. Herein, a liquid supply pump 5 may be disposed in the liquid storage part 11, to pump the liquid coolant to the flow distribution manifold 17 from the liquid storage part 11, so that the liquid coolant is distributed to each server node.

Certainly, the flow distribution manifold 17 may alternatively be arranged inside the housing 1 (not shown in the figure). The flow distribution manifold 17 located inside the housing 1 needs to occupy an internal space of the housing 1, the condensation component 2 needs to be moved backward correspondingly, and the vapor coolant travels an increased distance to reach the surface of the condensation heat exchange pipe. Compared with the arrangement manner in which the flow distribution manifold 17 is located inside the housing 1, in the implementation shown in the figure, the vapor coolant can quickly reach the surface of the heat exchange pipe 23, thereby implementing heat dissipation and condensation with relatively good heat exchange efficiency.

In a specific implementation, according to an overall product design requirement, the manifold body of the flow distribution manifold 17 may alternatively not be arranged in the vertical direction, to adapt to an interface position form on a device chassis side, thereby meeting a structural configuration of a specific product.

In another specific implementation, the manifold body of the flow distribution manifold 17 may alternatively be in a form of a non-straight manifold according to an actual requirement. In comparison, the flow distribution manifold 17 in the implementation shown in the figure is a straight manifold body, so that flow resistance of the liquid coolant in the manifold is relatively small, and energy consumption of coolant transportation can be properly controlled based on implementation of a function that the liquid coolant flows back to the server nodes.

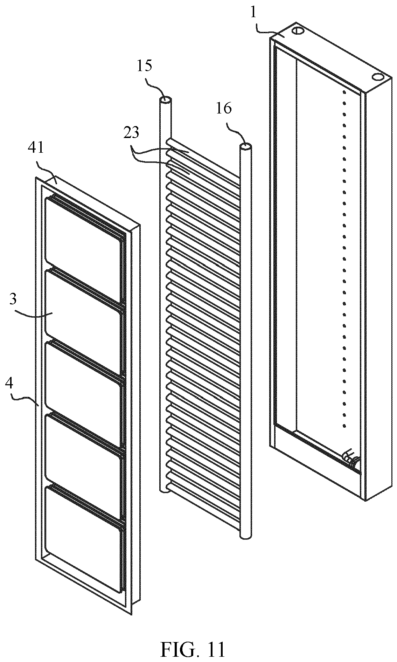

Usually, in a high power consumption operation state, a generation speed of the vapor coolant is relatively high. When a condensation speed provided by the condensation component 2 is less than a vapor generation speed, a pressure in the housing 1 increases. To implement system pressure balancing, this implementation further includes an adjustment component 3. Refer to FIG. 2, FIG. 3, FIG. 10, and FIG. 11. FIG. 11 is another exploded view of assembly of a phase-change liquid immersion cooling system-based coolant distribution unit according to an embodiment of this application.

The adjustment component 3 is disposed on a rear side of the housing 1, and an internal cavity of the adjustment component 3 is communicated with an internal cavity of the housing 1. A main body of the adjustment component 3 may deform under the action of a pressure on an internal cavity side of the adjustment component 3, so that an accommodating space of the internal cavity of the adjustment component 3 is enlarged or narrowed as the pressure changes. The "deformation" herein includes a case in which the main body of the adjustment component 3 can deform in a single dimension, and further includes a case in which the main body of the adjustment component 3 can deform in a multi-dimensional manner. In the working process, the component in the device chassis 101 generates heat, and the heat is exchanged to the liquid coolant in the device chassis. The liquid coolant is vaporized when the temperature exceeds the boiling point of the two-phase coolant, and enters the housing 1 through the vapor path adaptively established by using the vapor connector 103 and the vapor connector 14. When a vaporization speed is greater than the condensation speed, an internal pressure also increases. Based on a feature that the adjustment component 3 may deform under the pressure, a system internal pressure may be released after the main body of the adjustment component 3 deforms and expands, so that a system pressure is effectively balanced, thereby avoiding an adverse impact caused by an increase in the internal pressure, for example, but not limited to, a boiling point of a coolant increases due to an excessively high pressure, which may cause a damage to a chip due to overtemperature, and avoiding affecting normal working of some pressure-sensitive components and another potential safety hazard. In general, system operation can be maintained at normal pressure, thereby reducing a pressure fluctuation amplitude in the working process and ensuring stable and reliable system operation.

Herein, the main body of the adjustment component 3 may use a heat insulation means, for example, but not limited to, a heat insulation foam layer is coated on a surface of the main body of the adjustment component 3, or a double-layer heat insulation structure is used for the main body of the adjustment component 3, to prevent heat from spreading to an external environment.

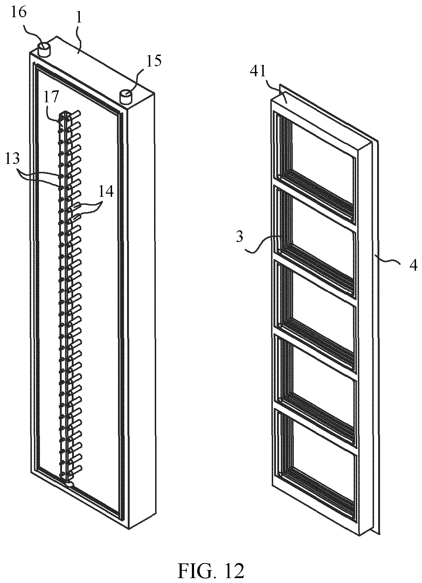

To facilitate performing a maintenance operation, in this implementation, a plurality of adjustment components 3 are disposed, and are separately fastened on the rear side of the housing 1 by using a mounting bracket 4. Without loss of generality, in this solution, five adjustment components 3 are used as description objects to describe in detail an assembly relationship between the adjustment components 3 and the mounting bracket 4. Refer to FIG. 11 and FIG. 12. FIG. 12 is an exploded view of another assembly of a phase-change liquid immersion cooling system-based coolant distribution unit according to an embodiment of this application.

As shown in the figure, the mounting bracket 4 includes an external frame 41. The external frame 41 has five adjustment component mounting positions, and correspondingly, the rear side of the housing 1 has an opening that is fit with the mounting bracket 4. As shown in FIG. 12, the main body of each adjustment component 3 is an accordion-type extension structure, and an opening of the adjustment component 3 is disposed toward the housing 1. After being assembled on the external frame 41, the adjustment components 3 are fixedly inserted into the opening on the rear side of the housing 1 by using the external frame 41. The foregoing communication relationship has good sealing and fastening relationship. In this way, internal cavities of the adjustment components 3 are communicated with the internal cavity of the housing 1, and deform under the action of the internal pressure to change accommodating spaces of the internal cavities of the adjustment components 3.

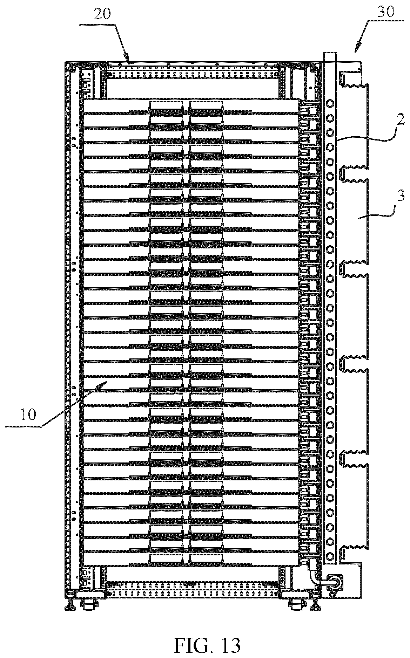

FIG. 13 is a diagram of the adjustment component 3 in an expanded use state. As shown in the figure, the adjustment components 3 expand under the action of the system internal pressure. Herein, expansion sizes of the adjustment components 3 are the same. In actual application, when pressures of regions in which the adjustment components 3 are located are different, corresponding actual expansion amounts are not completely the same. In addition, for a case in which vaporization speeds in the server nodes 10 are different, redundancy supplement between corresponding regions in which the adjustment components 3 are located can be provided based on expansion adjustment capabilities of the internal cavities of the adjustment components 3.

Herein, the adjustment components 3 are sequentially arranged from top to bottom within an amplitude range formed by the opening on the rear side of the housing 1. That is, space occupation of the adjustment components 3 in the height direction and the width direction tends to be consistent with those of the housing 1 and a device whose heat is to be dissipated. As shown in the figure, the coolant distribution unit 30 is in a vertical form as a whole. In such disposition, on the one hand, pressure changes in regions in which the vapor connectors 103 are located can be processed more effectively in a timely manner. In addition, the adjustment components 3 make full use of horizontal and vertical dimensional spaces. On a basis of providing a same pressure balancing capability, a size of the adjustment component 3 in the front-rear direction is properly controlled, so that an integration degree of the entire unit is high. In addition, space occupation in an expanded state may be reduced in the front-rear direction, thereby facilitating overall deployment of an application space such as an equipment room.

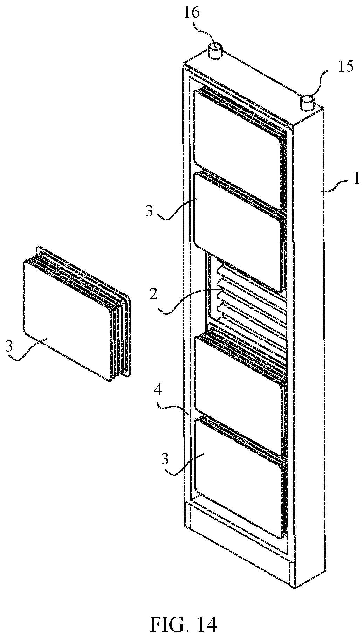

In addition, in a specific implementation, the plurality of adjustment components 3 may alternatively be sequentially arranged from left to right within the amplitude range formed by the opening on the rear side of the housing 1, or arranged in a staggered manner. In other specific application, one adjustment component 3 may alternatively be disposed, for example, but limited to, to adapt to the amplitude range formed by the opening on the rear side of the housing 1. In comparison, based on a structural feature that the plurality of adjustment components 3 are disposed and are separately mounted by using the mounting bracket 4, the coolant distribution unit 30 does not need to be detached for maintenance. When maintenance needs to be performed, some of the adjustment components 3 are detached for a maintenance operation, so that an actual workload and working intensity are relatively small. Therefore, operability is good. For details, refer to FIG. 14. The figure shows a maintenance state of the coolant distribution unit.

It should be noted that, by using a structure of the main body of the adjustment component 3, the main body of the adjustment component 3 can deform under the action of the internal pressure to change the accommodating space of the internal cavity. In another specific implementation, the foregoing function may alternatively be implemented by selecting a material for the main body of the adjustment component, for example, but not limited to, by using a main body that is flexible after formation. In addition, the main body has elasticity based on a feature of the material, so that a size of the internal accommodating space can also be adjusted or changed under the action of the internal pressure.

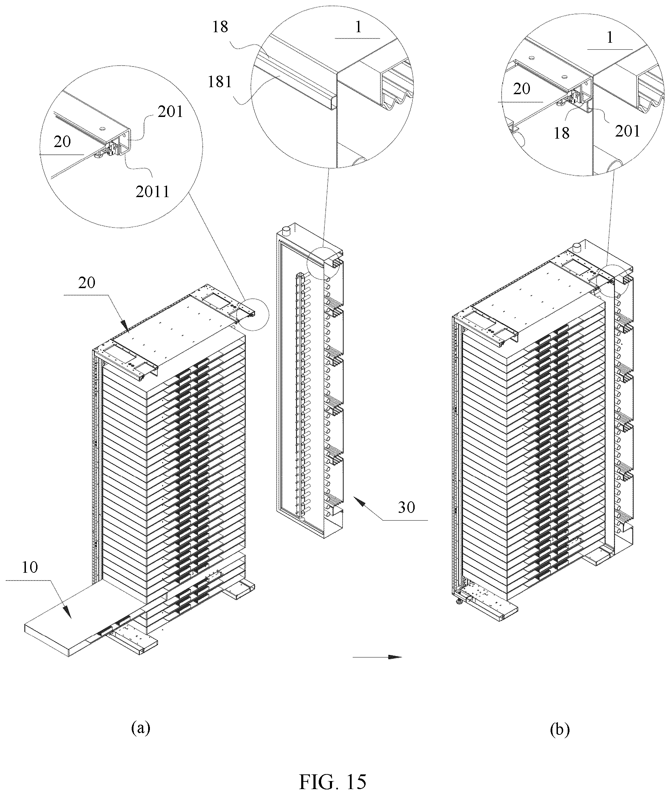

In this implementation, a fastening structure of the coolant distribution unit 30 may be integrated on a frame of the cabinet body 20, so that an assembly and fastening structure of the coolant distribution unit 30 is simplified, thereby reducing space occupation on the rear side, and reducing manufacturing costs to some extent. FIG. 15 is a diagram of an assembly relationship between the coolant distribution unit 30 and the cabinet body 20. To clearly show a fastening structure between the coolant distribution unit 30 and the cabinet body 20, a corresponding diagram is formed in the figure by cutting and removing a part of composition.

With reference to (a) of FIG. 15, a first connection frame 201 is disposed on a rear end side of the cabinet body 20, the first connection frame 201 extends inwards from an outer edge of the cabinet body 20 to form a first mounting rabbet 2011. The first connection frame 201 may be fixedly connected in different manners, for example, but not limited to, be formed integrally with an outer edge of a rear end of the cabinet body by using a sheet metal process. A second connection frame 18 is disposed on a front end side of the coolant distribution unit 30, and the second connection frame 18 extends forward from the front surface of the housing 1, to form a second mounting rabbet 181. The second connection frame 18 may also be fixedly connected in different manners, for example, but not limited to, be welded to the housing 1 after being formed through sheet metal molding or profile machining molding.

With reference to (b) of FIG. 15, the second connection frame 18 is inserted into the first connection frame 201, to implement assembly and positioning based on the first mounting rabbet 2011 and the second mounting rabbet 181, so that the coolant distribution unit 30 is fastened on a rear side of the cabinet body 20. Therefore, spaces in the height and width directions are fully used without occupying an effective space inside the cabinet body, and a system integration degree is high. Based on this, the coolant distribution unit 30 that provides functions of condensation and heat exchange, air management, and pressure control for the server nodes 10 may be delivered and transported as an assembly with the cabinet body 20.

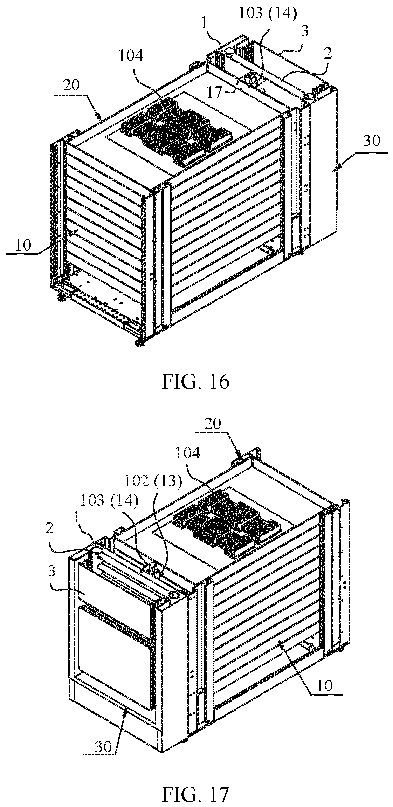

After being transported to the site, the server nodes 10 are sequentially inserted into the cabinet body 20 from a front side of the cabinet body 20, and there is no need to assemble a phase-change liquid immersion cooling system on site, thereby reducing difficulty of on-site mounting. After the server nodes 10 are inserted in position, the quick connectors of the server nodes are connected to and fit with the quick connectors of the coolant distribution unit 30, to implement liquid path communication and vapor path communication, thereby implementing circulation working of the phase-change liquid immersion cooling system. FIG. 16 and FIG. 17 are respectively diagrams formed through cutting from a position E-E shown in FIG. 1.

Certainly, in another specific implementation, according to different on-site construction conditions, the coolant distribution unit 30 and the cabinet body 20 may alternatively be separately delivered, and the coolant distribution unit 30 is assembled at a rear part of the cabinet body 20 on site.

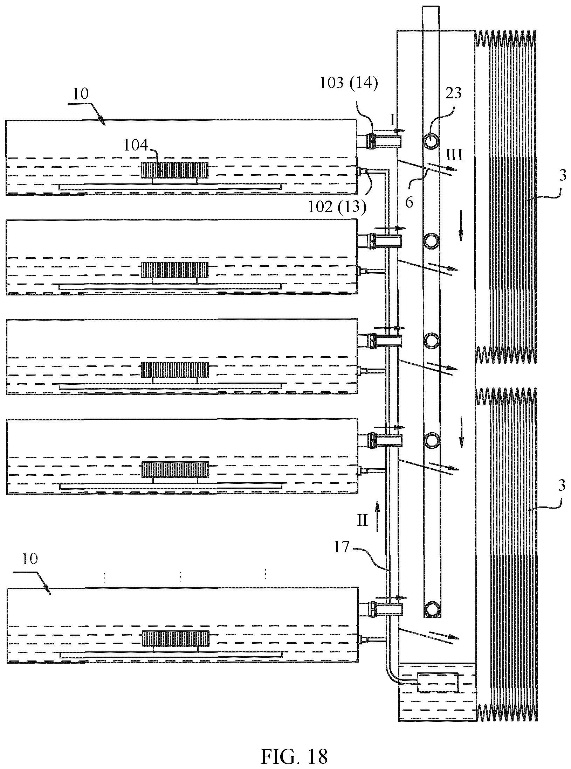

The following briefly describes a working principle of this implementation by using a diagram of a principle of a phase-change liquid immersion cooling system-based coolant distribution unit shown in FIG. 18.

First, after a phase-change liquid immersion cooling server works, heat generated when the heating component 104 works is exchanged to the liquid coolant, and the liquid coolant is vaporized when the temperature raises to exceed the boiling point of the coolant. The vapor coolant enters the housing 1 of the coolant distribution unit 30 through the vapor path (shown as an arrow I in FIG. 18) adaptively established by using the vapor connector 103 and the vapor connector 14. Then, after entering the coolant distribution unit 30, the vapor coolant is cooled on the surface of the heat exchange pipe of the condensation component 2. The vapor coolant exchanges heat with the condensation component 2 based on the low-temperature cooling water circularly flowing in the condensation heat exchange pipe, the heat is transferred to the cooling water in the condensation heat exchange pipe, the vapor coolant condenses and is liquefied, and the liquid coolant drops and is collected into the liquid storage part 11 below.

The liquid coolant in the liquid storage part 11 is pumped to the flow distribution manifold 17 (shown as an arrow II in FIG. 18) under the action of the liquid supply pump 5, flows back to the device chassis 101 through the flow distribution manifold 17 and the liquid path established by using the liquid connector 13 and the liquid connector 102, and enters the next cycle.

In the working process, when the system internal pressure changes after vaporization, the space of the internal cavity of the adjustment component 3 may be adjusted and changed correspondingly. When the pressure increases, the adjustment component 3 expands to enlarge the space, and when the pressure decreases, the adjustment component 3 may be retracted to narrow the space, to balance the system internal pressure and an external atmospheric pressure.

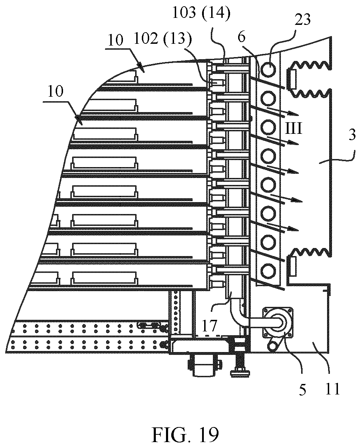

For the heat exchange pipes 23 that are sequentially arranged from top to bottom, the liquid coolant formed through condensation on a surface of an upper heat exchange pipe drops downward. To prevent the liquid coolant that drops downward from attaching to a surface of a lower heat exchange pipe, and avoid affecting contact and heat exchange between the condensation heat exchange pipe and the vapor coolant, in another specific implementation, a flow guiding baffle 6 may be disposed below the heat exchange pipe 23. Refer to FIG. 18 and FIG. 19. FIG. 19 is another view of a local part of a phase-change liquid immersion cooling system-based coolant distribution unit.

As shown in FIG. 19, in this implementation, the flow guiding baffle 6 may be separately fixedly configured below the heat exchange pipes 23. An extension end of the flow guiding baffle 6 is located on a side of the heat exchange pipe 23. In this way, when the liquid coolant drops downward, the liquid coolant first reaches the flow guiding baffle 6 below the liquid coolant, is guided to the side of the heat exchange pipe 23 by the flow guiding baffle 6 for dropping (shown as an arrow III in FIG. 18 and FIG. 19), and is collected into the liquid storage part 11. As shown in the figure, the flow guiding baffle 6 is an inclined flat plate, and has a simple structure and is easy to manufacture.

In a specific implementation, it should be understood that the flow guiding baffle 6 may alternatively be in another form provided that the liquid coolant formed through condensation on the upper heat exchange pipe 23 the flow guiding baffle 6 can be guided to the side.

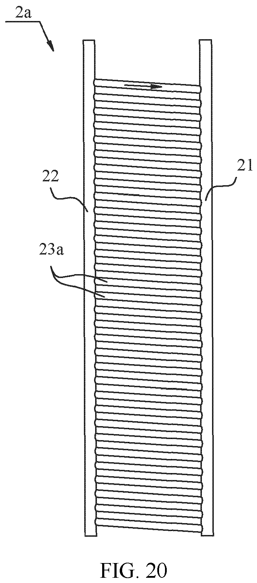

In addition, in another specific implementation, a pipe body of the heat exchange pipe may alternatively be inclined. FIG. 20 is a diagram of an overall structure of another condensation component.

A condensation component 2a shown in FIG. 20 and the condensation component 2 in the embodiment shown in FIG. 11 have same main body composition, and both include a water inlet pipe 21 and a water outlet pipe 22. In addition, a plurality of heat exchange pipes are communicatively arranged between the water inlet pipe 21 and the water outlet pipe 22. A main difference of this implementation lies in that pipe bodies of heat exchange pipes 23a are all inclined. In such disposition, a liquid coolant formed through condensation on a surface of the heat exchange pipe 23a may flow to a lower end along the inclined pipe body. In this way, an amount of liquid that directly drops downward can be reduced, thereby reducing an impact on condensation efficiency of a lower heat exchange pipe 23a.

In another specific implementation, the heat exchange pipe, as a main heat exchange member of the condensation component, may not be a straight pipe or may be in an arrangement form that is not in a horizontal attitude. A function of shortening an arrival path of the vapor coolant can be implemented to some extent, provided that the heat exchange pipe 23 includes a pipe body part that is disposed opposite to a corresponding vapor connector 14 in the front-rear direction.

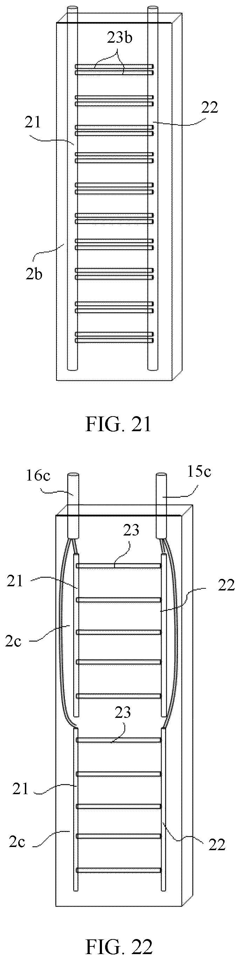

FIG. 21 is a diagram of still another condensation component according to an embodiment of this application.

As shown in FIG. 21, a condensation component 2b includes a water inlet pipe 21 and a water outlet pipe 22, a plurality of heat exchange pipes 23b are communicatively disposed between the water inlet pipe 21 and the water outlet pipe 22, and two adjacent heat exchange pipes 23b form a group. It can be understood that each group of heat exchange pipes may be configured as three or more adjacent heat exchange pipes 23b.

In specific application, each group of heat exchange pipes 23b may correspond to a vapor outlet (not shown in the figure) of the vapor connector 14, to specifically improve condensation and heat exchange efficiency. Herein, quantities of heat exchange pipes configured for the server nodes may be the same or different, to properly configure a liquid cooling heat exchange capability according to an actual heat dissipation requirement.

FIG. 22 is a diagram of another condensation component according to an embodiment of this application.

As shown in FIG. 22, two condensation components 2c are disposed. Each condensation component 2c includes a water inlet pipe 21 and a water outlet pipe 22, and a plurality of heat exchange pipes 23 are communicatively arranged between the water inlet pipe 21 and the water outlet pipe 22. Water inlet pipes 21 of the two condensation components 2c are communicated in parallel with a cooling water inlet 16c, and water outlet pipes 22 of the two condensation components 2c are communicated in parallel with a cooling water outlet 15c. Certainly, in another specific implementation, a quantity of condensation components 2c that are configured in parallel may be configured according to a heat dissipation requirement.

Therefore, parallel cooling water circulation is established based on the two condensation components 2c, so that cooling water flow rates of the condensation components can be flexibly adjusted, and properly distributed according to a specific heat dissipation requirement.

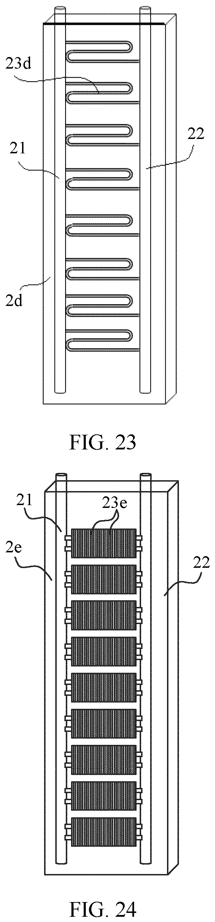

FIG. 23 is a diagram of still another condensation component according to an embodiment of this application.

As shown in FIG. 23, a condensation component 2d includes a water inlet pipe 21 and a water outlet pipe 22, a plurality of heat exchange pipes 23d are communicatively disposed between the water inlet pipe 21 and the water outlet pipe 22, and a main body of the heat exchange pipe 23d is in a Z shape, so that heat exchange efficiency of each heat exchange pipe 23d is improved. The heat exchange pipe 23d shown in the figure includes a horizontally extended pipe section. Alternatively, another irregular main body that is not in the Z shape may be used.

In addition, based on the condensation components described in FIG. 11 and FIG. 20 to FIG. 23, the server nodes 10 of the system may be horizontally inserted. In another specific implementation, the nodes may alternatively be vertically inserted. A vapor communication relationship and a liquid communication relationship may also be quickly established with the coolant distribution unit 30 after the server nodes are inserted in position, provided that the liquid connector 102 and the vapor connector 103 are inserted and configured at a rear end of a corresponding device chassis 101.

Compared with the manner in which the nodes are vertically inserted, according to the manner in which the nodes are horizontally inserted, a phase-change heat dissipation capability is better, a component immersion area of a component in the chassis is relatively large, and an overall heat dissipation capability is stronger. In addition, for the manner in which the nodes are vertically inserted, at least one flow distribution manifold needs to be arranged for each row of node to establish the liquid path communication relationship. However, the server nodes 10 horizontally inserted in the entire cabinet body may be sequentially arranged based on one flow distribution manifold 17, and fully distributed on the rear side of the entire cabinet. Therefore, a structure is simple and manufacturability is good.

Further, the main heat exchange member of the condensation component may alternatively be a heat exchange fin structure communicated in parallel between the water inlet pipe and the water outlet pipe.

FIG. 24 is a diagram of another condensation component according to an embodiment of this application.

A condensation component 2e includes a water inlet pipe 21 and a water outlet pipe 22. A plurality of groups of heat exchange fins 23e are sequentially connected in series to a communication branch pipe. A cooling water flow channel of each heat exchange fin 23e is separately communicated with the water inlet pipe 21 and the water outlet pipe 22 through the communication branch pipe. That is, each group of heat exchange fins 23e is communicated in parallel between the water inlet pipe 21 and the water outlet pipe 22.

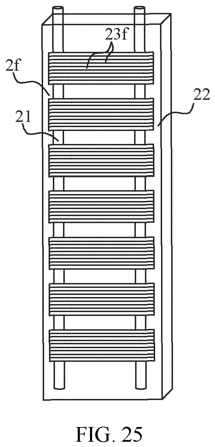

FIG. 25 is a diagram of still another condensation component according to an embodiment of this application.

A condensation component 2f includes a water inlet pipe 21 and a water outlet pipe 22. A plurality of groups of heat exchange fins 23e are sequentially connected in series to the water inlet pipe 21 and the water outlet pipe 22. That is, the heat exchange fins 23e are communicated in parallel between the water inlet pipe 21 and the water outlet pipe 22.

In a specific application scenario, based on the condensation components described in FIG. 24 and FIG. 25, each group of heat exchange fins may correspond to one or more server nodes.

An embodiment of this application further provides a computing device. The computing device includes a device chassis that performs component heat dissipation based on a phase-change liquid immersion cooling system, and further includes the phase-change liquid immersion cooling system-based coolant distribution unit that is described in FIG. 1 to FIG. 23.

The computing device may be of a product type such as a computer or a server, and is particularly applicable to a data center server with a high power, a high integration degree, and an ultra-large scale. Based on an operation mechanism of the phase-change liquid immersion cooling system, an internal space expansion capability in corresponding cooling circulation may be met. In addition, provided coolant circulation condensation function and coolant supply function provide a technical support for reliable application of phase-change liquid immersion cooling in heat dissipation processing of a corresponding component.

It should be understood that other functions of a corresponding computing device are not a core invention point of this application. Therefore, details are not described in this specification.

The above are only the implementations of the present invention, and it should be noted that for a person of ordinary skill in the art, several improvements and modifications may be made without departing from the principle of the present invention, and these improvements and modifications should also be regarded as falling within the protection scope of the present invention.

## Claims

1. A phase-change liquid immersion cooling system-based coolant distribution unit, wherein the coolant distribution unit comprises an external housing configured to be disposed on a back surface of a device chassis and a condensation component built in the housing; a front surface of the housing is configured as a condensation region wall surface, and the condensation region wall surface and the condensation component are disposed opposite to each other in a front-rear direction; and a liquid connector and a vapor connector are disposed on the condensation region wall surface, and the liquid connector and the vapor connector are configured to be disposed opposite to and respectively adaptively connected to connectors of a vapor introduction port and a liquid introduction port disposed on the device chassis.

2. The phase-change liquid immersion cooling system-based coolant distribution unit according to claim 1, further comprising an adjustment component, wherein the adjustment component comprises a main body having an internal cavity, the main body of the adjustment component may deform under the action of a pressure on an internal cavity side of the adjustment component, to correspondingly change an accommodating space of the internal cavity of the adjustment component, and the internal cavity of the adjustment component is communicated with an internal cavity of the housing.

3. The phase-change liquid immersion cooling system-based coolant distribution unit according to claim 2, wherein the adjustment component is located on a rear side of the housing, and is capable of extending and contracting in the front-rear direction to change the accommodating space of the internal cavity of the adjustment component.

4. The phase-change liquid immersion cooling system-based coolant distribution unit according to claim 3, wherein a plurality of adjustment components are sequentially disposed in an up-and-down direction.

5. The phase-change liquid immersion cooling system-based coolant distribution unit according to any one of claims 1 to 4, further comprising a flow distribution manifold disposed on the housing, wherein the flow distribution manifold is configured to communicate with a liquid storage part, and a plurality of liquid connectors are disposed and are inserted into the flow distribution manifold.

6. The phase-change liquid immersion cooling system-based coolant distribution unit according to claim 5, wherein the flow distribution manifold is fastened on the front surface of the housing.

7. The phase-change liquid immersion cooling system-based coolant distribution unit according to claim 5 or 6, further comprising a liquid supply pump, configured to transport a liquid coolant in the liquid storage part to the flow distribution manifold.

8. The phase-change liquid immersion cooling system-based coolant distribution unit according to any one of claims 1 to 7, wherein a plurality of groups of liquid connectors and vapor connectors are disposed, and each group comprises at least one liquid connector and at least one vapor connector.

9. The phase-change liquid immersion cooling system-based coolant distribution unit according to claim 8, wherein the plurality of groups of liquid connectors and vapor connectors are sequentially disposed from top to bottom, and the liquid connectors and the vapor connectors are quick connectors.

10. The phase-change liquid immersion cooling system-based coolant distribution unit according to claim 1, wherein the condensation component comprises a water inlet pipe, a water outlet pipe, and a heat exchange member separately communicated between the water inlet pipe and the water outlet pipe, and the heat exchange member comprises a cooling water flow channel communicated with the water inlet pipe and the water outlet pipe.

11. The phase-change liquid immersion cooling system-based coolant distribution unit according to claim 10, wherein at least two condensation components are disposed, and water inlet pipes and water outlet pipes of the at least two condensation components are communicated in parallel.

12. The phase-change liquid immersion cooling system-based coolant distribution unit according to claim 10 or 11, wherein the heat exchange member is a heat exchange pipe, and the vapor connector is disposed opposite to the heat exchange pipe in the front-rear direction.

13. The phase-change liquid immersion cooling system-based coolant distribution unit according to claim 12, wherein a through-flow center of the vapor connector intersects with a center of a corresponding heat exchange pipe, or a through-flow section of the vapor connector at least partially overlaps a surface of a main body of the heat exchange pipe.

14. The phase-change liquid immersion cooling system-based coolant distribution unit according to any one of claims 10 to 13, wherein the water inlet pipe and the water outlet pipe are vertically disposed, a plurality of heat exchange pipes are configured, and the plurality of heat exchange pipes each comprise a horizontally extended pipe section.

15. The phase-change liquid immersion cooling system-based coolant distribution unit according to claim 14, wherein a flow guiding baffle is disposed at least below the horizontally extended pipe section of the heat exchange pipe, and an extension end of the flow guiding baffle is located on a side of the heat exchange pipe.

16. The phase-change liquid immersion cooling system-based coolant distribution unit according to any one of claims 12 to 15, wherein a pipe body of the heat exchange pipe is inclined.

17. The phase-change liquid immersion cooling system-based coolant distribution unit according to any one of claims 1 to 16, wherein a top or a bottom of the housing comprises a cooling water outlet and a cooling water inlet, and the cooling water outlet and the cooling water inlet are respectively communicated with the water outlet pipe and the water inlet pipe of the condensation component.

18. The phase-change liquid immersion cooling system-based coolant distribution unit according to any one of claims 1 to 17, wherein the liquid storage part is disposed at the bottom of the housing, and the condensation component is located above the liquid storage part.

19. A computing device, comprising a device chassis that performs component heat dissipation based on a phase-change liquid immersion cooling system, and further comprising the phase-change liquid immersion cooling system-based coolant distribution unit according to any one of claims 1 to 18, wherein a liquid connector and a vapor connector on the device chassis are located on a back surface of the device chassis, and the liquid connector and the vapor connector on the device chassis are respectively adaptively connected to the liquid connector and the vapor connector on the housing, to respectively establish a liquid path communication relationship and a vapor path communication relationship.

20. The computing device according to claim 19, wherein the device chassis comprises a plurality of node device chassis, and the liquid connectors and the vapor connectors on the housing are respectively communicated with liquid connectors and vapor connectors of the plurality of node device chassis in one-to-one correspondence.

21. The computing device according to claim 20, wherein the computing device is a server.

22. The computing device according to claim 21, wherein the computing device is a server cabinet, and the plurality of node device chassis are horizontally inserted into a cabinet body.
